# EUROPEAN PATENT APPLICATION

(11) **EP 4 757 499 A1**
(43) Date of publication of application: **10.06.2026**
(21) Application number: 25217017.0
(22) Date of filing: 19.11.2025
(51) Int. Cl.: H05K 1/02, H05K 7/20, H05K 1/181

(54) **POWER MODULES WITH ENHANCED THERMAL CONDUCTIVITY**

(30) Priority: 09.12.2024 US 202418973542
(71) Applicant: Analog Devices, Inc., Wilmington, MA 01887 (US)
(72) Inventor: Paduvalli, Vikas, Wilmington 01887 (US); Pham, Hien Minh, Wilmington 01887 (US)
(74) Representative: Horler, Philip John

(57) **Abstract**

Power modules with enhanced thermal conductivity are disclosed herein. In certain embodiments, a power module includes a circuit board, an inductor component attached to a first or top side of the circuit board, and a semiconductor die attached to a second or bottom side of the circuit board opposite the first side. The power module further includes a thermally conductive wrap at least partially around a dielectric body of the inductor component. The thermally conductive wrap serves to transfer heat from the semiconductor die to a cold plate or heat sink that can be attached to the inductor component opposite the circuit board.

## Description

This application claims the benefit of priority from US patent application no. 18/973,542 filed 9 December 2024.

### FIELD OF THE DISCLOSURE

Embodiments of the invention relate to electronic systems, and more particularly, to power modules for providing power regulation.

### BACKGROUND

A power module can include one or more switching regulators that operate in combination with one or more inductors to provide power regulation. For example, the switching regulator can employ switches (for instance, power transistors) coupled in series and/or parallel with an output terminal that provides an output voltage to a load through an inductor. Additionally, a controller turns the switches ON and OFF to control delivery of current pulses to the output terminal through the inductor, which converts the switched pulses into a steady load current.

A power module can include a semiconductor die on which metal-oxide-semiconductor field-effect transistors (MOSFET) and a driver are formed. Such a semiconductor die is referred to as a driver and MOSFET (DrMOS) die or integrated circuit (IC).

### SUMMARY OF THE DISCLOSURE

Power modules with enhanced thermal conductivity are disclosed herein. In certain embodiments, a power module includes a circuit board, an inductor component attached to a first or top side of the circuit board, and a semiconductor die attached to a second or bottom side of the circuit board opposite the first side. The power module further includes a thermally conductive wrap at least partially around a dielectric body of the inductor component. The thermally conductive wrap serves to transfer heat from the semiconductor die to a cold plate or heat sink that can be attached to the inductor component opposite the circuit board. By implementing the power module in this manner, low interconnect losses are achieved between the semiconductor die and the inductor component. At the same time excellent thermal performance is achieved since the thermally conductive wrap can efficiently transfer heat to the cold plate and/or heat sink.

In one aspect, a power module includes a circuit board having a first side and a second side opposite the first side. The power module further includes an inductor component attached to the first side of the circuit board, the inductor component having a dielectric body. The power module further includes a semiconductor die attached to the second side of the circuit board, and a thermally conductive wrap at least partially around the dielectric body of the inductor component, the thermally conductive wrap including a first portion between the dielectric body and the circuit board.

In another aspect, a power regulation system includes a customer board and a power module attached to the customer board. The power module includes a circuit board having a first side and a second side opposite the first side. The power module further includes an inductor component attached to the first side of the circuit board, the inductor component having a dielectric body. The power module further includes a semiconductor die attached to the second side of the circuit board, and a thermally conductive wrap at least partially around the dielectric body of the inductor component, the thermally conductive wrap including a first portion between the dielectric body and the circuit board.

In another aspect, a method of assembling a power module is provided. The method includes wrapping a thermally conductive wrap at least partially around a dielectric body of an inductor component. The method further includes attaching the inductor component to a first side of a circuit board, the thermally conductive wrap including a first portion between the dielectric body and the circuit board. The method further includes attaching a semiconductor die to a second side of the circuit board opposite the first side.

### BRIEF DESCRIPTION OF THE DRAWINGS

Figure 1A is a front view of a power module according to one embodiment.
Figure 1B is a side view of the power module of Figure 1A.
Figure 1C depicts the power module of Figure 1A attached to a customer circuit board and cold plate/heat sink.
Figure 2A is a perspective view of a power module according to another embodiment.
Figure 2B is a side view of the power module of Figure 2A attached to a customer circuit board and cold plate/heat sink.
Figure 3A is a first portion of a method of assembling a power module according to one embodiment.
Figure 3B is a second portion of the method of assembling the power module.
Figure 3C is a third portion of the method of assembling the power module.
Figure 3D is a fourth portion of the method of assembling the power module.
Figure 3E is a fifth portion of the method of assembling the power module.
Figure 4 is a perspective view of a power module according to another embodiment.
Figure 5A is a perspective view of the circuit board of the power module of Figure 4 with the lead frame removed.
Figure 5B is a perspective view of the circuit board of the power module of Figure 4 with the lead frame attached but prior to removal of tie bars.
Figure 6 is a perspective view of another embodiment of a power module attached to a customer circuit board.
Figure 7 is a circuit diagram of a power module according to one embodiment.
Figure 8A is a perspective view of another embodiment of a power module shown with an inductor component detached from a circuit board.
Figure 8B is a perspective view of the power module of Figure 8A with the inductor component attached to the circuit board.
Figure 8C is a cross-section of the power module of Figure 8B along the lines 8C-8C.
Figure 8D is a plan view of the power module of Figure 8B.

### DETAILED DESCRIPTION OF EMBODIMENTS

The following detailed description of embodiments presents various descriptions of specific embodiments of the invention. However, the invention can be embodied in a multitude of different ways. In this description, reference is made to the drawings where like reference numerals may indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Existing packaging techniques for power modules pose a challenge for thermal performance. For example, a power module can include an inductor and a semiconductor die (for example, a DrMOS die) that regulates a current through the inductor. To lower thermal resistance, there is a desire to position the semiconductor die as close as possible to a heat sink. However, positioning the semiconductor die in this manner results in higher interconnect losses between the semiconductor die and the inductor.

Power modules with enhanced thermal conductivity are disclosed herein. In certain embodiments, a power module includes a circuit board, an inductor component attached to a first or top side of the circuit board, and a semiconductor die attached to a second or bottom side of the circuit board opposite the first side. The power module further includes a thermally conductive wrap at least partially around a dielectric body of the inductor component. The thermally conductive wrap serves to transfer heat from the semiconductor die to a cold plate or heat sink that can be attached to the inductor component opposite the circuit board.

By implementing the power module in this manner, low interconnect losses are achieved between the semiconductor die and the inductor component. At the same time excellent thermal performance is achieved since the thermally conductive wrap can efficiently transfer heat to the cold plate and/or heat sink.

In certain implementations, the thermally conductive wrap is at least partially metallic. For example, the thermally conductive wrap can correspond to a copper wrap that at least partially surrounds the dielectric body of the inductor component. Thus, the thermally conductive wrap can serve to draw heat directly from the semiconductor die through metallic connections. In some implementations, the thermally conductive wrap also carries an electrical signal or a ground or power supply. Thus, the thermally conductive wrap can be multi-functional.

The inductor component can include a dielectric body (for example, a ferrite core) and one or more inductors (for instance, copper windings) that extend through the dielectric body. In certain implementations, each of the inductor(s) is electrically connected to a corresponding output of the semiconductor die. The number of inductors included in the inductor component can correspond to a desired number of phases for power regulation. In a first example, one inductor is included to provide a single-phase power module. In another example, two inductors are included to provide a two-phase (2-phase) power module.

In certain implementations, the thermally conductive wrap is directly soldered to the circuit board with no thermal interfacing material (Tim) present. By including solderable interfaces between components, thermal conductivity can be enhanced. For example, when the thermally conductive wrap is directly soldered to the circuit board, heat can be drawn from the semiconductor die through metal vias of the circuit board to the wrap, and thereafter travel to the heat sink and/or cold plate with low thermal resistance. Accordingly, heat can be efficiently removed from the power module.

In addition to including one or more semiconductor dies (for instance, a DrMOS die), additional components can be attached to the circuit board using surface mount technology (SMT). In one example, surface mount components such as capacitors are included alongside the semiconductor die.

The semiconductor die operates to regulate a current through one or more inductors formed through the dielectric body of the inductor component. In certain implementations, the semiconductor is a DrMOS die.

In certain implementations, the semiconductor die is packaged (for instance, in a quad flat no-lead (QFN) package, a land grid array (LGA) package, or other suitable package) and attached to the circuit board.

In one example, the semiconductor die and SMT components are attached to the circuit board, and a lead frame is placed over the semiconductor die and SMT components. The lead frame is thereafter molded and pin separated (for example, by cutting tie bars). In such an implementation, the pins of the lead frame can serve as pins for interfacing the power module with a customer circuit board.

In another example, the semiconductor die is attached by a flip-chip process to the circuit board and encapsulated along with SMT components and pads using a mold compound. In such implementations, grinding can be performed on a back side of the encapsulation to expose the pads and/or a portion of the semiconductor die.

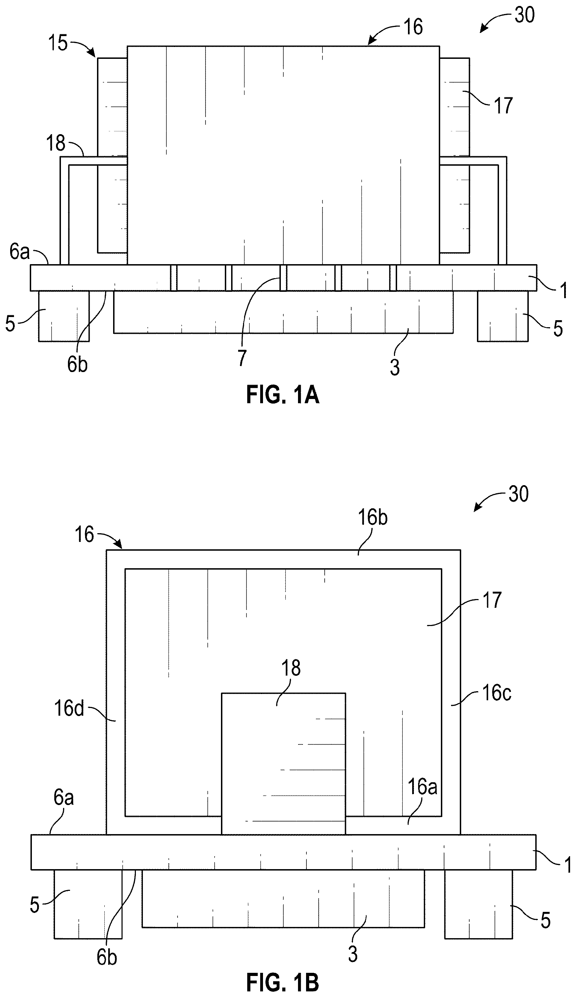

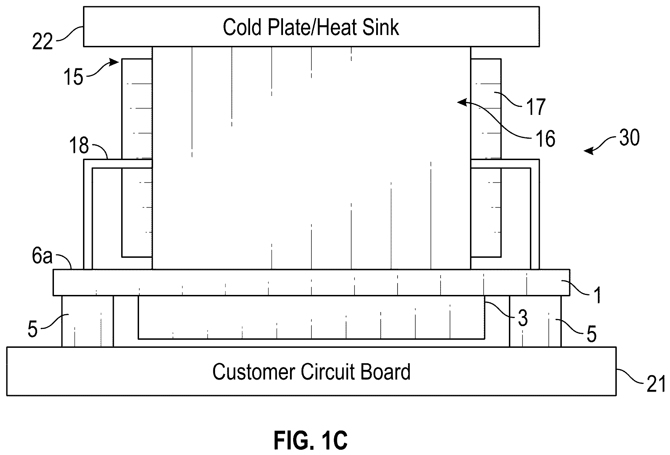

Figure 1A is a front view of a power module 30 according to one embodiment. Figure 1B is a side view of the power module 30 of Figure 1A. Figure 1C depicts the power module 30 of Figure 1A attached to a customer circuit board 21 and a cold plate and/or heat sink (cold plate/heat sink) 22.

With reference to Figures 1A-1C, the power module 30 includes a circuit board 1, a semiconductor die 3, vertical interconnects 5, an inductor component 15, and a thermally conductive wrap 16. The inductor component 15 includes a dielectric body 17 (for example, a ferrite core) and an inductor 18 (for example, a copper winding) formed through the dielectric body 17.

The power module 30 of Figures 1A-1C depicts an example of a single-phase power module. However, the teachings herein are applicable to power modules with a different number of phases.

In the illustrated embodiment, a bottom surface of the inductor component 15 is attached to a first or top side 6a of the circuit board 1. Additionally, a first or bottom portion 16a of the thermally conductive wrap 16 is interposed between the dielectric body 17 and the circuit board 1.

In certain implementations, the thermally conductive wrap 16 is directly soldered to the top side 6a of the circuit board 1. Thus, the first portion 16a of the thermally conductive wrap 16 can connect to the circuit board 1 by solder with no Tim therebetween. By soldering the thermally conductive wrap 16 to the circuit board 1, heat can be drawn from the semiconductor die 3 through metal vias 7 of the circuit board 1 to the wrap 16, and thereafter travel to the heat sink/cold plate 22 with low thermal resistance. Accordingly, heat can be efficiently removed from the power module 30.

In the illustrated embodiment, the thermally conductive wrap 16 also includes a second or top portion 16b opposite the circuit board 1 that can be attached to the cold plate/heat sink 22. In this example, a third or right portion 16c of the thermally conductive wrap 16 connects the bottom portion 16a to the top portion 16b along a right side of the inductor component 15, while a fourth or left portion 16d of the thermally conductive wrap 16 connects the bottom portion 16a to the top portion 16b along a left side of the inductor component 15.

Accordingly, the thermally conductive wrap 16 serves as an effective conduit for heat traveling from the semiconductor die 3 to the cold plate/heat sink 22.

Although an example in which the thermally conductive wrap 16 fully wraps around the perimeter of the dielectric body 17 is shown, the teachings herein are also applicable to configurations in which a thermally conductive wrap only partially wraps around the dielectric body of an inductor component.

With continuing reference to Figures 1A-1C, the semiconductor die 3 and vertical interconnects 5 are attached to a second or bottom side 6b of the circuit board 1. In certain implementations, the semiconductor die 3 corresponds to a packaged semiconductor die, and can include various components (for example, capacitors) within the package.

The semiconductor die 3 can operate to regulate a current through the inductor 18. For example, the semiconductor die 3 can correspond to a DrMOS that having an output electrically connected to a first end of inductor 18 while a second end of the inductor 18 can connect to a corresponding output voltage (VOUT) terminal of the customer circuit board 21.

In the illustrated embodiment, the vertical interconnects 5 are attached to the bottom side 6b of the circuit board 1 and can connect to corresponding terminals of the customer circuit board 21. The vertical interconnects 5 can be used to carry various power and ground supplies as well as signals. Thus, the vertical interconnects 5 serve to provide electrical connections to a larger electronic system.

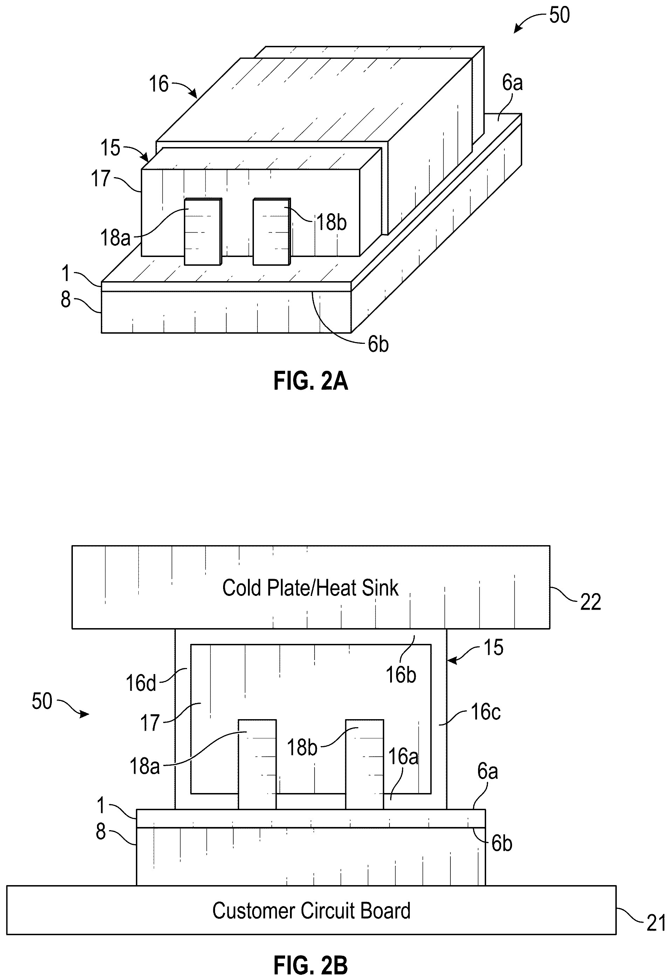

Figure 2A is a perspective view of a power module 50 according to another embodiment. Figure 2B is a side view of the power module 50 of Figure 2A attached to a customer circuit board 21 and cold plate/heat sink 22.

With reference to Figures 2A-2B, the power module 50 includes a circuit board 1, encapsulation 8, an inductor component 15, and a thermally conductive wrap 16. The inductor component 15 includes a dielectric body 17 (for example, a ferrite core), and inductors 18a/18b (for example, copper windings) formed through the dielectric body 17. The inductor component 15 is attached to a top surface 6a of the circuit board 1 with the thermally conductive wrap 16 wrapped around the inductor component 15. Additionally, the encapsulation 8 is formed over a bottom surface 6b of the circuit board 1.

The power module 50 of Figure 2A-2B is similar to the power module 30 of Figures 1A-1C, except that the power module 50 depicts an example of a multi-phase inductor component and in which the power module 50 includes the encapsulation 8.

For example, in the illustrated embodiment two inductors 18a/18b are included in the inductor component 15 to provide a two-phase power module. However, the teachings herein are applicable to power modules including more or fewer phases.

Furthermore, the encapsulation 8 is included over the bottom surface 6b of the circuit board 1. The encapsulation 8 is formed over a semiconductor die, SMT components, and vertical interconnects (not shown in Figures 2A-2B) to form an overmold.

Thus, the power module 50 of Figures 2A-2B depicts an example in which a power module includes a semiconductor die is encapsulated. One example of an assembly process for a power module that includes encapsulation will now be described.

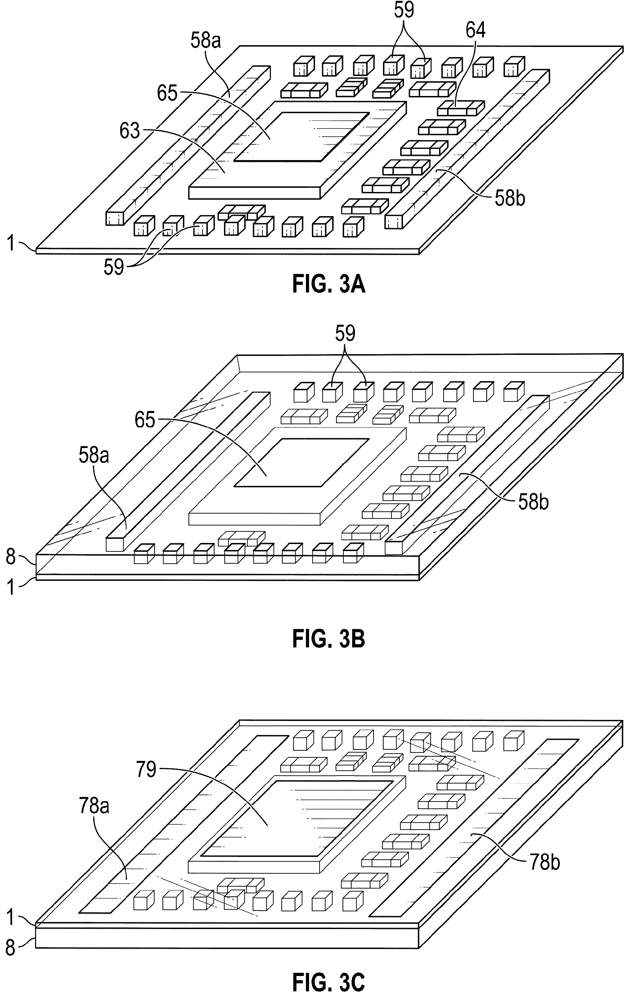

Figures 3A-3E depicts a method of assembling a power module according to one embodiment. Although one embodiment of assembling a power module is shown, power modules can be assembled in other ways. Accordingly, other implementations are possible.

With reference to Figure 3A, the method begins by attaching various structures to the back side of the circuit board 1. The attached structures include inductor pins 58a/58b, other pins 59, the semiconductor die 63, and the surface mount components 64, in this example.

After assembly, the depicted pins serve as an electrical interface for a customer circuit board. The pins include a first inductor pin 58a for connecting to a first terminal of an inductor and a second inductor pin 58b for connecting to a second terminal of an inductor. The pins also include other pins 59 that can carry signals, power, ground, and/or provide other electrical connections as desired.

The surface mount components 64 can include capacitors and/or other passive and/or active components desired for a particular application.

As shown in Figure 3A, a die pad 65 has been included over the semiconductor die 3, in this embodiment. The die pad 65 can provide a number of functions including helping to transfer heat from the power module and/or to carry a ground voltage. Thus, in some implementations, the die pad 65 serves at least in part as a ground pin.

With reference to Figure 3B, encapsulation 8 has been formed over the circuit board 1 and subsequently grinded to expose the pins 58a/58b/59 as well as the die pad 65.

In Figure 3C a top side of the circuit board 1 is shown. The top side includes a first inductor terminal landing pad 78a, a second inductor terminal landing pad 78b, and a thermal interface pad 79. The first inductor terminal landing pad 78a electrically connects to the first inductor pin 58a, while the second inductor terminal landing pad 78b electrically connects to the second inductor pin 58b. The thermal interface pad 79 serves as a soldering pad for soldering a wrapped inductor component, and thus can also be referred to as the solderable thermal interface pad 79. The solderable thermal interface pad 79 is thermally coupled to the semiconductor die 63 that is within the encapsulation 8. In some implementations, the depicted pads are formed from metallization (for example, copper) of the circuit board 1.

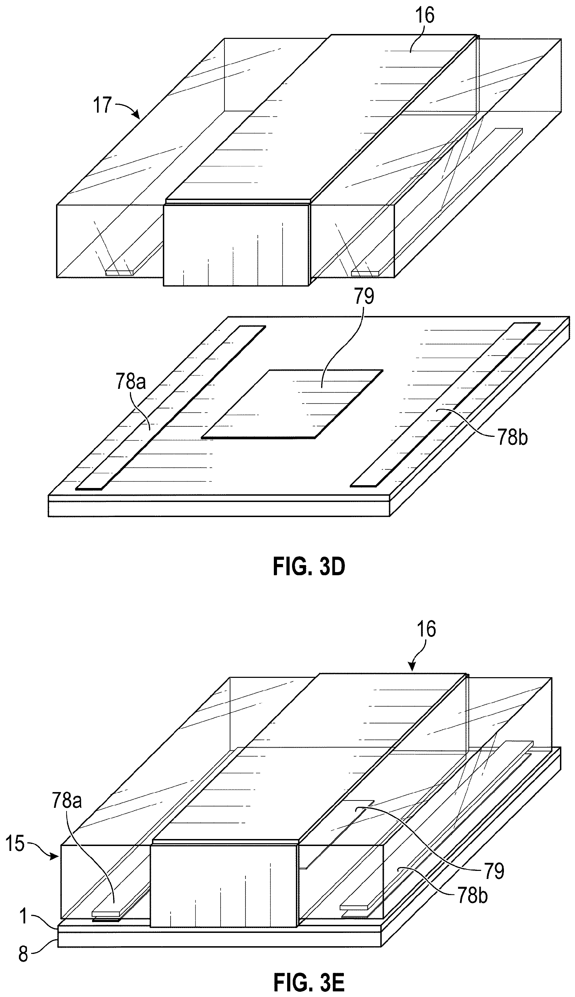

With reference to Figure 3D and 3E, and inductor component 15 is soldered to the top surface of the circuit board 1. For example, electrical terminals of the inductor component 15 are soldered to the inductor terminal landing pads 78a/78b, while the thermally conductive wrap 16 is soldered to the solderable thermal interface pad 79. The inductor component 15 includes an inductor (not shown in Figures 3D and 3E for clarity of the figures) through the dielectric body 17. The inductor terminal landing pads 78a/78b correspond to terminals of the inductor.

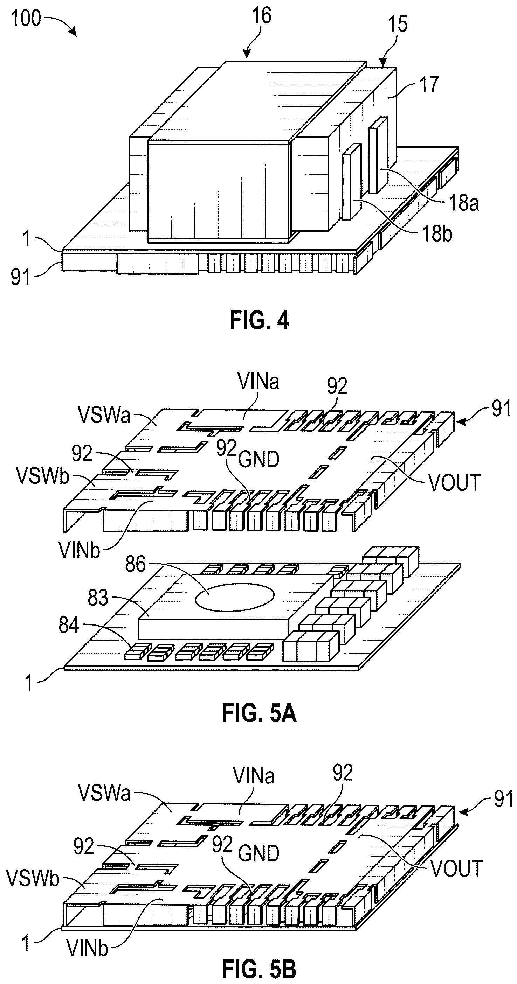

Figure 4 is a perspective view of a power module 100 according to another embodiment. The power module 100 includes a circuit board 1, a lead frame 91, and an inductor component 15. The inductor component 15 includes a first inductor 18a and a second inductor 18b formed through a dielectric body 17. Figure 5A is a perspective view of the circuit board 1 of the power module 100 of Figure 4 with the lead frame 91 removed. Figure 5B is a perspective view of the circuit board 1 of the power module 100 of Figure 4 with the lead frame 91 attached but prior to removal of tie bars 92.

With reference to Figures 4 to 5B, the lead frame 91 includes various pins for connecting to a customer board. For example, the pins include a first switching output pin VSWa, a first input voltage pin VINa, a second switching output pin VSWb, a second input voltage pin VINb, a ground voltage pin GND, an output voltage pin VOUT, as well as various other pins for carrying signals and/or providing other desired electrical connectivity. The first switching output pin VSWa can be electrically connected to a first terminal of the first inductor 18a, while the output voltage pin VOUT can be electrically connected to a second terminal of the first inductor 18a. Additionally, the second switching output pin VSWb can be electrically connected to a first terminal of the second inductor 18b, while the second terminal of the second inductor 18b can be electrically connected to the output voltage pin VOUT.

When initially attaching the lead frame 91 to the circuit board 1, the tie bars 92 can be present. However, the lead frame 91 can be subsequently molded and pin separated by cutting the tie bars 92.

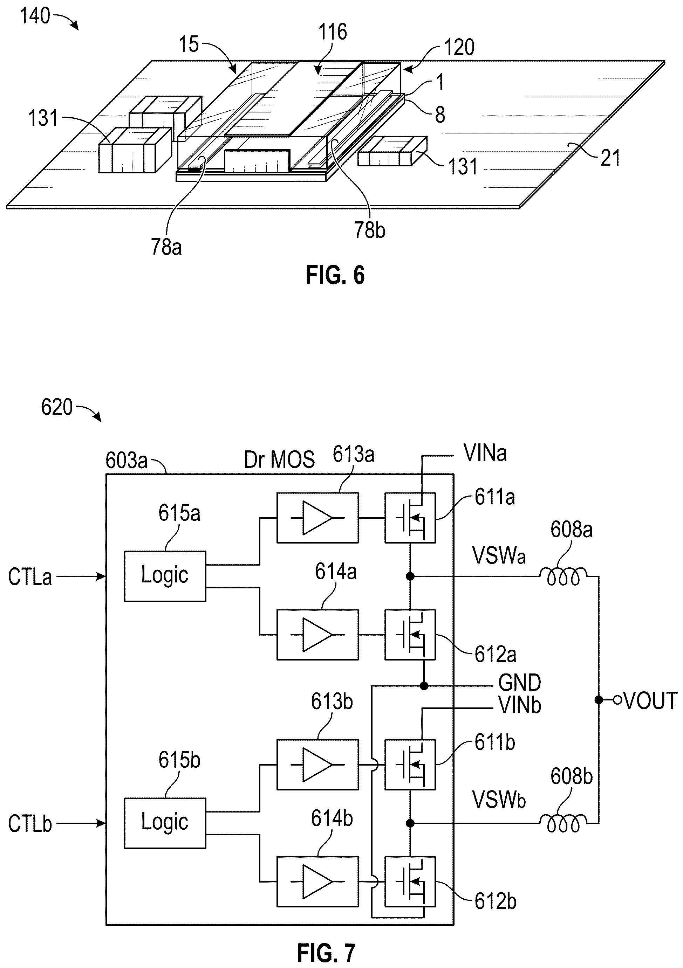

Figure 6 is a perspective view of another embodiment of a power module 120 attached to a customer circuit board 21. Various other components 131 have also been attached to the customer circuit board 21.

The power module 120 of Figure 6 is similar to the power module shown in Figure 3E, except that the thermally conductive wrap 116 of Figure 6 does not fully wrap around the power module 120.

Figure 7 is a circuit diagram of a power module 620 according to one embodiment. The power module 620 includes a 2-phase DrMOS die 603a that regulates a current through a first inductor 608a and a second inductor 608b. Although an example of a 2-phase power module is depicted, a power module can include more or fewer phases as needed for a particular application.

In the illustrated embodiment, the DrMOS die 603a includes a first high side power MOSFET 611a, a first low side power MOSFET 612a, a first high side driver 613a, a first low side driver 614a, a first driver logic circuit 615a, a second high side power MOSFET 611b, a second low side power MOSFET 612b, a second high side driver 613b, a second low side driver 614b, and a second driver logic circuit 615b.

Although one example of a DrMOS die is shown, DrMOS dies can be implemented in other ways. Accordingly, other implementations are possible. Furthermore, although certain components of the DrMOS dies are depicted, DrMOS dies can include additional circuitry and/or other pin configurations.

In the illustrated embodiment, an input control signal INa is provided to the logic 615a. The logic 615a controls driver signals to the high side driver 613a and the low side driver 614a, which control the high side power MOSFET 611a and low side power MOSFET 612a, respectively. The high side power MOSFET 611a and low side power MOSFET 612a are coupled to a first terminal VSWa of the inductor 608a to form a half bridge circuit of a switching regulator, such as a buck converter. The MOSFETs 612a/612b are switched on and off to control a current provided to the inductor 608a. A second terminal of the inductor 608a electrically connects to an output voltage pin VOUT for a customer circuit board.

With continuing reference to Figure 7, an input control signal INb is provided to the logic 615b. The logic 615b controls driver signals to the high side driver 613b and the low side driver 614b, which control the high side power MOSFET 611b and low side power MOSFET 612b, respectively. The high side power MOSFET 611b and low side power MOSFET 612b are coupled to a first terminal VSWb of the inductor 608b and are switched on and off to control a current provided to the inductor 608b. A second terminal of the inductor 608b electrically connects to the output voltage pin VOUT.

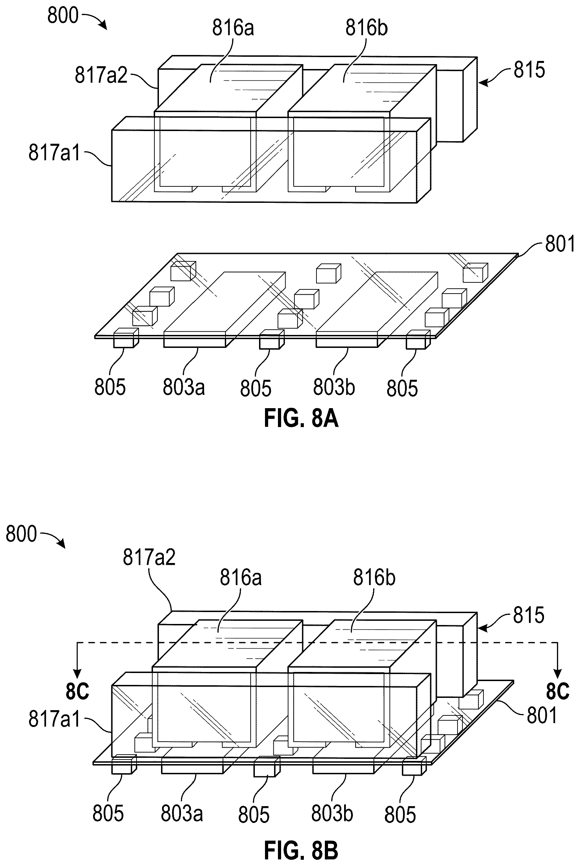

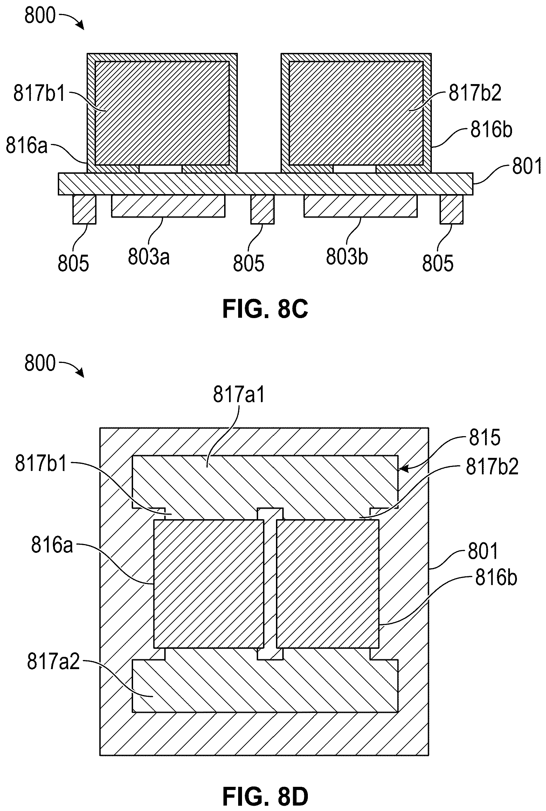

Figure 8A is a perspective view of another embodiment of a power module 800 shown with an inductor component 815 detached from a circuit board 801. Figure 8B is a perspective view of the power module 800 of Figure 8A with the inductor component 815 attached to the circuit board 801. Figure 8C is a cross-section of the power module 800 of Figure 8B along the lines 8C-8C. Figure 8D is a plan view of the power module 800 of Figure 8B.

In the illustrated embodiment, after assembly the inductor component 815 is attached to a top side of the circuit board 801, while a first semiconductor die 803a, a second semiconductor die 803b, and vertical interconnects 805 are connected to a bottom side of the circuit board 801. Although one example of a circuit board is shown, the circuit board 801 can be implemented in other ways, such as using encapsulation techniques and/or lead frames.

In comparison to the embodiments of Figures 1A-6 in which the inductor component's dielectric body is shaped as a rectangular prism, in the illustrated embodiment the inductor component 815 has a more complex shape. For example, the dielectric body of the inductor component 815 includes a first outer region 817a1, a second outer region 817a2 parallel to the first outer region 817a1, and inner regions 817b1/817b2 connecting the first outer region 817a1 to the second outer region 817a2. In one implementation, the dielectric body (for example, a ferrite core) of the inductor component 815 corresponds to an E core and I core put together. In another implementation, the dielectric body of the inductor component 815 corresponds to a U core and an I core put together.

The inductor components herein can include dielectric bodies shaped in a wide variety of ways, for example, as desired for a particular power module and/or power regulation application. In addition to having various shapes, the dielectric body of an inductor component can include recesses, trenches, ridges, and/or other structures to aid in achieving desired inductance characteristics.

In the illustrated embodiment, a first thermally conductive wrap 816a wraps around the first inner region 817b1 and a second thermally conductive wrap 816b wraps around the second inner region 817b2. The thermally conductive wraps 816a/816b serve to transfer heat from the semiconductor dies 803a/803b, respectively, to a cold plate or heat sink that can be attached to the inductor component 815 opposite the circuit board 801.

As shown in Figures 8A-8C, the first thermally conductive wrap 816a only partially wraps around the first inner region 817b1 and the second thermally conductive wrap 816b only partially wraps around the second inner region 817b2. In this embodiment, the first thermally conductive wrap 816a and the second thermally conductive wrap 816b also serve as inductors, and thus only partially wrap around the inductor component's dielectric body so that each end of the wrap serves as a terminal for the inductor. In some implementations, the wraps 816a/816b can be coated with an insulation coating.

The thermally conductive wraps 816a/816b can serve as inductors used for power regulation. For example, in some implementations, a first end of the first thermally conductive wrap 816a electrically connects to a switching output VSWa of the first semiconductor die 3a, a second end of the first thermally conductive wrap 816a electrically connects to an output voltage terminal VOUT being regulated, a first end of the second thermally conductive wrap 816b electrically connects to a switching output VSWb of the second semiconductor die 3b, and a second end of the second thermally conductive wrap 816b electrically connects to the output voltage terminal VOUT.

### Applications

Devices employing the above-described schemes can be implemented into various electronic devices in a wide range of applications including, but not limited to, bus converters, high current distributed power systems, telecom systems, datacom systems, storage systems, and automotive systems. Thus, examples of electronic devices that can be implemented with the power modules herein include, but are not limited to, communication systems, consumer electronic products, electronic test equipment, communication infrastructure, servers, automobiles, etc.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only and are not intended to limit the scope of the disclosure. Indeed, the novel apparatus, methods, and systems described herein may be embodied in a variety of other forms; furthermore, various omissions, substitutions, and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments. Accordingly, the scope of the present invention is defined only by reference to the appended claims.

Although the claims presented here are in single dependency format for filing at the USPTO, it is to be understood that any claim may depend on any preceding claim of the same type except when that is clearly not technically feasible.

### ASPECTS OF THE DISCLOSURE

Non-limiting aspects of the disclosure are set out in the following numbered clauses.
1. A power module comprising:
   a circuit board having a first side and a second side opposite the first side;
   an inductor component attached to the first side of the circuit board, the inductor component having a dielectric body;
   a semiconductor die attached to the second side of the circuit board; and
   a thermally conductive wrap at least partially around the dielectric body of the inductor component, the thermally conductive wrap including a first portion between the dielectric body and the circuit board.
2. The power module of clause 1, wherein the thermally conductive wrap includes a second portion opposite the first portion, and a third portion connecting the first portion to the second portion along a side of the dielectric body.
3. The power module of any preceding clause, wherein the thermally conductive wrap is at least partially metallic.
4. The power module of any preceding clause, wherein the thermally conductive wrap fully wraps around the dielectric body of the inductor component.
5. The power module of any preceding clause, wherein the thermally conductive wrap partially wraps around the dielectric body of the inductor component, and the thermally conductive wrap operates as an inductor.
6. The power module of any preceding clause, further comprising a lead frame over the semiconductor die on the second side of the circuit board.
7. The power module of clause 6, wherein a plurality of pins of the lead frame serve as an electrical interface to a customer circuit board.
8. The power module of any preceding clause, further comprising an encapsulation formed over the semiconductor die on the second side of the circuit board.
9. The power module of clause 8, further comprising a plurality of pins through the encapsulation to form an electrical interface to a customer circuit board.
10. The power module of any preceding clause, wherein the thermally conductive wrap is directly soldered to the first surface of the circuit board.
11. The power module of clause 9, wherein the circuit board includes a plurality of metal vias for transferring heat from the semiconductor die to the thermally conductive wrap.
12. The power module of any preceding clause, wherein the inductor component includes a first inductor formed through the dielectric body, wherein a first terminal of the inductor is electrically connected to an output of the semiconductor die.
13. The power module of any preceding clause, wherein the dielectric body includes a ferrite core.
14. A power regulation system comprising:
   a customer board; and
   a power module attached to the customer board, the power module comprising:
      a circuit board having a first side and a second side opposite the first side;
      an inductor component attached to the first side of the circuit board, the inductor component having a dielectric body;
      a semiconductor die attached to the second side of the circuit board; and
      a thermally conductive wrap at least partially around the dielectric body of the inductor component, the thermally conductive wrap including a first portion between the dielectric body and the circuit board.
15. The power regulation system of clause 12, further comprising at least one of a heat sink or a cold plate attached to the inductor component opposite the customer board.
16. The power regulation system of clause 12 or clause 15, wherein the thermally conductive wrap is at least partially metallic.
17. The power regulation system of any of clauses 12 to 16, wherein the thermally conductive wrap fully wraps around the dielectric body of the inductor component.
18. A method of assembling a power module, the method comprising:
   wrapping a thermally conductive wrap at least partially around a dielectric body of an inductor component;
   attaching the inductor component to a first side of a circuit board, the thermally conductive wrap including a first portion between the dielectric body and the circuit board; and
   attaching a semiconductor die to a second side of the circuit board opposite the first side.
19. The method of clause 14 wherein attaching the inductor component to the first side of the circuit board includes directly soldering the thermally conductive wrap to the first surface of the circuit board.
20. The method of clause 14 or clause 19 wherein wrapping the thermally conductive wrap at least partially around the dielectric body of the inductor component includes wrapping copper fully around the dielectric body of the inductor component.

## Claims

1. A power module comprising:
a circuit board having a first side and a second side opposite the first side;
an inductor component attached to the first side of the circuit board, the inductor component having a dielectric body;
a semiconductor die attached to the second side of the circuit board; and
a thermally conductive wrap at least partially around the dielectric body of the inductor component, the thermally conductive wrap including a first portion between the dielectric body and the circuit board.

2. The power module of claim 1, wherein the thermally conductive wrap includes a second portion opposite the first portion, and a third portion connecting the first portion to the second portion along a side of the dielectric body.

3. The power module of any preceding claim, wherein the thermally conductive wrap is at least partially metallic.

4. The power module of any preceding claim, wherein the thermally conductive wrap fully wraps around the dielectric body of the inductor component.

5. The power module of any preceding claim, wherein the thermally conductive wrap partially wraps around the dielectric body of the inductor component, and the thermally conductive wrap operates as an inductor.

6. The power module of any preceding claim, further comprising a lead frame over the semiconductor die on the second side of the circuit board.

7. The power module of claim 6, wherein a plurality of pins of the lead frame serve as an electrical interface to a customer circuit board.

8. The power module of any preceding claim, further comprising an encapsulation formed over the semiconductor die on the second side of the circuit board,
and optionally further comprising a plurality of pins through the encapsulation to form an electrical interface to a customer circuit board.

9. The power module of any preceding claim, wherein the thermally conductive wrap is directly soldered to the first surface of the circuit board,
and optionally wherein the circuit board includes a plurality of metal vias for transferring heat from the semiconductor die to the thermally conductive wrap

10. The power module of any preceding claim, wherein the inductor component includes a first inductor formed through the dielectric body, wherein a first terminal of the inductor is electrically connected to an output of the semiconductor die.

11. The power module of any preceding claim, wherein the dielectric body includes a ferrite core.

12. A power regulation system comprising:
a customer board; and
the power module of any preceding claim, wherein the power module is attached to the customer board.

13. The power regulation system of claim 12, further comprising at least one of a heat sink or a cold plate attached to the inductor component opposite the customer board.

14. A method of assembling a power module, the method comprising:
wrapping a thermally conductive wrap at least partially around a dielectric body of an inductor component;
attaching the inductor component to a first side of a circuit board, the thermally conductive wrap including a first portion between the dielectric body and the circuit board; and
attaching a semiconductor die to a second side of the circuit board opposite the first side.

15. The method of claim 14 wherein at least one of the following applies:
(a) attaching the inductor component to the first side of the circuit board includes directly soldering the thermally conductive wrap to the first surface of the circuit board;
(b) wrapping the thermally conductive wrap at least partially around the dielectric body of the inductor component includes wrapping copper fully around the dielectric body of the inductor component.
